(19) Europäisches Patentamt

European Patent Office

Office européen des brevets

(11) **EP 4 002 370 B1**

(12) **FASCICULE DE BREVET EUROPEEN**

(45) Date de publication et mention de la délivrance du brevet:
**01.01.2025 Bulletin 2025/01**

(21) Numéro de dépôt: **21209143.3**

(22) Date de dépôt: **18.11.2021**

(51) Classification Internationale des Brevets (IPC):
***G11C 13/00*** *(2006.01)*

(52) Classification Coopérative des Brevets (CPC):
**G11C 13/0004; G11C 13/0061; G11C 13/0069;**
G11C 2013/0078; G11C 2013/0092

(54) **PROCÉDÉ DE PROGRAMMATION D'UNE MÉMOIRE À CHANGEMENT DE PHASE**

VERFAHREN ZUR PROGRAMMIERUNG EINES SPEICHERS MIT PHASENÄNDERUNG

METHOD FOR PROGRAMMING A PHASE-CHANGING MEMORY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.11.2020 FR 2012028**

(43) Date de publication de la demande:
**25.05.2022 Bulletin 2022/21**

(73) Titulaire: **Commissariat à l'Energie Atomique et aux Energies Alternatives**
**75015 Paris (FR)**

(72) Inventeurs:
• **NAVARRO, Gabriele**
  **38054 GRENOBLE CEDEX 09 (FR)**
• **SERRA, Anna-Lisa**
  **38054 GRENOBLE CEDEX 09 (FR)**
• **BOURGEOIS, Guillaume**
  **38054 GRENOBLE CEDEX 09 (FR)**
• **SABBIONE, Chiara**
  **38054 GRENOBLE CEDEX 09 (FR)**

(74) Mandataire: **Cabinet Beaumont**
**4, Place Robert Schuman**
**B.P. 1529**
**38025 Grenoble Cedex 1 (FR)**

(56) Documents cités:
**US-A1- 2010 097 851    US-B2- 8 634 235**

EP 4 002 370 B1

**Description**

Domaine technique

La présente invention concerne de façon générale les mémoires non volatiles, plus précisément les mémoires à changement de phase (ou PCM de l'anglais Phase Change Memory) et plus particulièrement au procédé de programmation de la mémoire.

Technique antérieure

Les mémoires à changement de phase ou PCM sont des mémoires non volatiles s'appuyant sur les propriétés des matériaux à changement de phase. Les matériaux à changement de phase ont, en effet, la capacité de basculer d'un état faiblement résistif à un état résistif grâce à son échauffement. Les mémoires à changement de phase tirent profit du fait que les résistances électriques des différents états des matériaux à changement de phase sont différentes afin de stocker des données.

Les programmations des mémoires à changement de phase sont généralement longues, il serait donc souhaitable de réduire ce temps de programmation afin d'augmenter la vitesse de programmation.

Les documents US 8634235 B2 et US 2010/097851 A1 décrivent des procédés de programmation d'un dispositif de mémoire à changement de phase multiniveaux. Résumé de l'invention

Il existe un besoin d'amélioration des procédés d'écriture des données des mémoires à changement de phase.

Un mode de réalisation pallie tout ou partie des inconvénients des procédés connus.

L'invention prévoit un procédé de programmation d'une mémoire à changement de phase comprenant une première couche d'un matériau à changement de phase capable de passer entre un état cristallin et un état amorphe et inversement, le procédé comprenant l'application d'un courant de programmation à travers la première couche de sorte qu'une évolution de la densité surfacique de ce courant en fonction du temps t décroisse à partir d'un premier niveau, entre un premier instant et un deuxième instant, en suivant une première évolution dans le temps respectant, ou étant proche de $J_0(\mathrm{t}) = \frac{K}{\sqrt{t}}$ où K est une constante.

La première évolution est proche de $J_0(\mathrm{t}) = \frac{K}{\sqrt{t}}$ si elle crée, lorsqu'elle est superposée à celle-ci, une ou plusieurs surfaces entre la première évolution et $J_0(\mathrm{t}) = \frac{K}{\sqrt{t}}$, et le rapport de l'aire de chaque surface avec l'intégrale de $J_0(\mathrm{t}) = \frac{K}{\sqrt{t}}$ entre les premier et deuxième instants est inférieur à 0,2.

Selon un mode de réalisation, la première évolution coupe $J_0(\mathrm{t}) = \frac{K}{\sqrt{t}}$ au moins en deux points entre les premier et deuxième instants.

Selon un mode de réalisation, avant le premier instant, l'évolution de la densité surfacique du courant en fonction du temps t, suit une deuxième évolution croissante linéaire entre un troisième instant et un quatrième instant puis une troisième évolution constante égale au premier niveau entre le quatrième instant et le premier instant.

Selon un mode de réalisation, la première évolution comprend plusieurs portions linéaires strictement décroissantes et/ou des proportions constantes, entre le premier instant et le deuxième instant.

Selon un mode de réalisation, la première couche repose sur un élément chauffant ou une électrode.

Selon un mode de réalisation, la première couche repose sur une deuxième couche à base de nitrure de germanium.

Selon un mode de réalisation, le courant de programmation est appliqué à travers la première couche et un canal dans la deuxième couche, une zone de contact entre le canal et la face inférieure de la première couche ayant une superficie inférieure à celle de la face inférieure de la première couche.

Selon un mode de réalisation, le canal est une zone confinée d'un matériau à changement de phase et est situé dans un filament de la deuxième couche, le procédé comprenant, après le deuxième instant, une étape de cristallisation de la zone confinée.

Selon un mode de réalisation, une cristallisation de la zone confinée est menée par une quatrième évolution linéaire constante de la densité de courant en fonction du temps, sur une première durée et dans lequel la première

$$t_{filament} = \frac{h_{filament}}{v_g}$$

durée est égale à $t_{filament} = \frac{h_{filament}}{v_g}$ avec $h_{filament}$ la hauteur moyenne de la zone confinée et avec $v_g$ la vitesse de cristallisation du matériau à changement de phase.

Selon un mode de réalisation, la cristallisation de la zone confinée est menée par une évolution linéaire strictement décroissante de la densité de courant en fonction du temps.

Selon un mode de réalisation, $K = \frac{1}{\sqrt{H}}$ où $H = \frac{v_g . R_{th} . A^2 . R_h}{h.(T_{melt} - T_h)}$ avec $R_{th}$ la résistance thermique de la cellule, $R_h$ la résistance électrique du matériau à changement de phase dans le filament, **A** la superficie de la zone de contact entre le filament et la face inférieure de la première couche, **h** la hauteur maximale du matériau à changement de phase, $T_{meit}$ la température de fusion du matériau à changement de phase, et avec $T_h$ la température de la première couche à sa face supérieure, c'est-à-dire à la face opposée à la face inférieure.

Selon un mode de réalisation, $K = \frac{1}{\sqrt{H'}}$ où $H' = \frac{v_g . R_{th} . A^2 . R_{h'}}{h.(T_{melt} - T_h)}$ avec $R_{th}$ la résistance thermique de la cellule, $R_h'$ la résistance électrique de l'élément chauffant, **A** la superficie de la zone de contact entre l'électrode ou l'élément chauffant et la face inférieure de la première couche, **h** la hauteur maximale du matériau à changement de phase, $T_{meit}$ la température de fusion du matériau à changement de phase, et avec $T_h$ la température de la première couche à sa face supérieure, c'est-à-dire à la face opposée à la face inférieure.

Selon un mode de réalisation, la durée entre les premier et deuxième instants, est égale à une deuxième durée

$$t_{dôme} = \frac{h.(T_{melt} - T_h)}{v_g . T_{melt}}$$ .

Selon un mode de réalisation, la durée entre les premier et deuxième instants est compris entre 1 ns et 1 ps.

Selon un mode de réalisation, le premier niveau est un niveau maximum que la densité de courant atteint par la cellule au cours des cycles de programmation.

Selon un mode de réalisation, l'application du courant de programmation correspond à une cristallisation d'une partie de la première couche.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, par une vue en perspective, partielle et schématique, un dispositif de mémoire à changement de phase ;

la figure 2 représente, par une vue en coupe, partielle et schématique, le dispositif à changement de phase de la figure 1 ;

la figure 3 représente, par une vue en coupe, partielle et schématique, un autre mode de réalisation d'un dispositif à changement de phase ;

la figure 4 représente, par une vue en coupe, partielle et schématique, encore un autre mode de réalisation d'un dispositif à changement de phase ;

la figure 5 est un schéma bloc illustrant un système de mémoire à changement de phase ;

la figure 6 est un graphique représentant un exemple de l'évolution de la densité de courant propagé dans le dispositif illustré en figure 3 en fonction du temps afin de basculer une partie des matériaux de ce dispositif d'un état résistif à un état moins résistif ;

la figure 7 est un graphique représentant un exemple de l'évolution de la densité de courant propagé dans le dispositif illustré en figure 3 en fonction du temps afin de basculer une partie des matériaux de ce dispositif d'un état résistif à un état moins résistif ;

la figure 8 est un graphique représentant un exemple de l'évolution de la densité de courant propagé dans le dispositif illustré en figure 3 en fonction du temps afin de basculer une partie des matériaux de ce dispositif d'un état résistif à un état moins résistif ;

la figure 9 est un graphique représentant un exemple de l'évolution de la densité de courant propagé dans le dispositif illustré en figure 3 en fonction du temps afin de basculer une partie des matériaux de ce dispositif d'un état résistif à un état moins résistif ;

la figure 10 est un graphique représentant un exemple de l'évolution de la densité de courant propagé dans le dispositif illustré en figure 3 en fonction du temps afin de basculer une partie des matériaux de ce dispositif d'un état résistif à un état moins résistif ;

la figure 11 est un graphique représentant un exemple de l'évolution de la densité de courant propagé dans le dispositif illustré en figure 2 en fonction du temps afin de basculer une partie des matériaux de ce dispositif d'un état résistif à un état moins résistif ; et

la figure 12 est un graphique représentant un exemple de réalisation de l'évolution de la densité de courant propagé dans le dispositif illustré en figure 2 en fonction du temps afin de basculer une partie des matériaux de ce dispositif d'un état résistif à un état moins résistif.

## Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

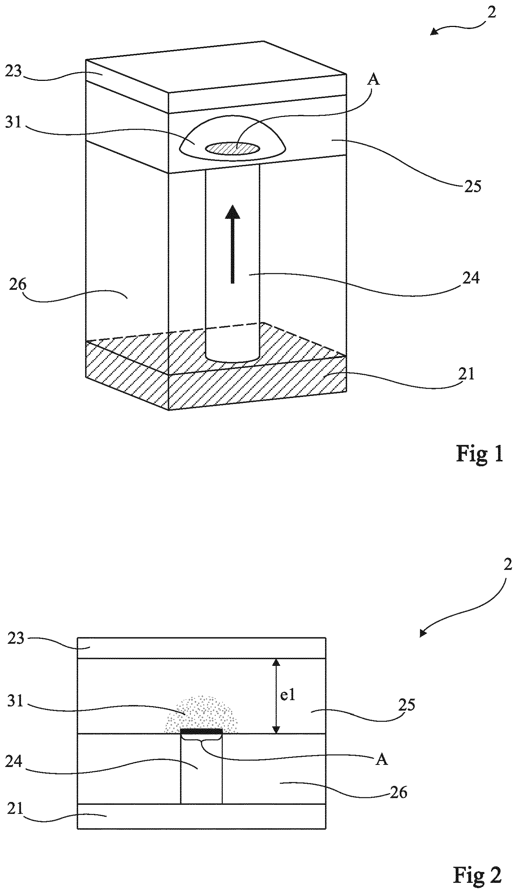

La figure 1 représente par une vue en perspective, partielle et schématique, un dispositif 2 mémoire à changement de phase.

Plus particulièrement, la figure 1 représente un dispositif 2 mémoire à changement de phase comprenant une première électrode 23, qui correspond par exemple à une électrode haute, une couche 25 d'un matériau à changement de phase et une deuxième électrode 21, qui correspond par exemple à une électrode basse.

Les deux électrodes 23 et 21 sont, par exemple, métalliques.

Le matériau à changement de phase est, par exemple, un matériau GST, c'est-à-dire un matériau composé de germanium (Ge), d'antimoine (Sb) et de tellure (Te).

Le dispositif 2 comprend, en outre, un élément chauffant (heater) 24 entre la deuxième électrode 21 et la couche 25 du matériau à changement de phase.

L'élément chauffant 24 est, par exemple, en tungstène ou en un alliage à base de titane ou de tantale.

Le matériau à changement de phase a la capacité de basculer d'un état résistif (HRS, High Résistive State) à un état faiblement résistif (LRS, Low Résistive State) sous l'effet de la chaleur et de l'effet Joule généré par l'application d'un courant entre les électrodes 21 et 23. Le basculement d'un état résistif à un état faiblement résistif correspond à une opération d'activation, dite SET, c'est-à-dire une opération d'écriture d'une valeur de donnée binaire, par exemple d'une valeur logique "1", et le basculement d'un état faiblement résistif à un état résistif correspond à une opération de désactivation, dite RESET, c'est-à-dire une opération d'écriture d'une valeur de donnée binaire opposée, par exemple d'une valeur logique "0".

Dans la présente description, l'état dit "résistif" peut, à titre d'exemple, être un état amorphe, c'est-à-dire un état désordonné ayant une résistance électrique élevée et l'état dit "moins résistif" ou "faiblement résistif" peut, à titre d'exemple, être un état cristallin ou partiellement cristallin, c'est-à-dire un état ordonné ayant une résistance électrique moindre.

Selon le mode de réalisation illustré en figure 2, le volume de la couche 25 affecté par les changements de phase correspond, par exemple, à un dôme 31. Dans l'exemple de la figure 1, l'élément chauffant 24 a une forme de cylindre. Dans une variante, l'élément chauffant 24 a une forme de parallélépipède rectangle droit. L'élément chauffant est, par exemple, entouré d'un isolant 26, généralement du $SiO_2$, de façon à augmenter la résistance thermique du dispositif et empêcher les dissipations thermiques par les bords de l'élément chauffant 24.

La figure 2 est une vue en coupe, partielle et schématique, du dispositif 2, la coupe traversant l'élément chauffant 24.

La face supérieure de l'élément chauffant 24 a une aire inférieure à l'aire de la face inférieure de la couche 25.

La couche 25 a, par exemple, une épaisseur e1 comprise entre 10 nm et 200 nm et égale, par exemple, à environ 50 nm. La couche 25 a, par exemple, une largeur comprise entre 3 nm et 500 nm et égale, par exemple, à environ 50 nm.

En figure 2, l'élément chauffant 24 a été représenté sous forme d'une couche. Toutefois, dans d'autres modes de réalisation, il peut avoir une forme quelconque, par exemple, la forme d'un "L".

Selon une variante du mode de réalisation de la figure 2, le dispositif 2 ne comprend pas d'électrode inférieure 21 et l'élément chauffant 24 fait office d'électrode ou inversement.

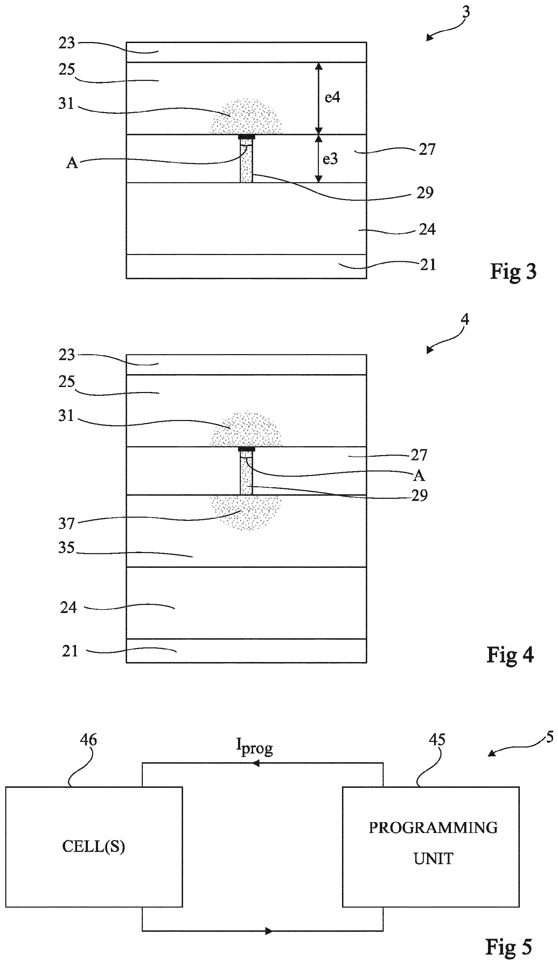

La figure 3 est une vue en coupe, partielle et schématique, d'une variante de réalisation du dispositif 2 illustré en figure 2.

Plus particulièrement, la figure 3 illustre un dispositif 3 similaire au dispositif 2 illustré en figure 2 à la différence près que le dispositif 3 comprend une couche 27, entre la couche 25 et l'électrode inférieure 21.

La couche 27 est située, par exemple, sur et en contact avec l'élément chauffant 24 et la couche 25 est située entre la couche 27 et l'électrode 23.

Selon un mode de réalisation, la couche 27 est composée d'un matériau à base de nitrure de germanium (GeN) ou d'un matériau diélectrique. Un filament est créé, dans la couche 27, par un phénomène dit de rupture ("breakdown" en anglais). Le filament s'étend, par exemple, de la face inférieure de la couche 27 à la face supérieure de la couche 27. La couche 27 est, par exemple, composée que de nitrure de germanium. Le filament est créé lors d'une étape, en début de vie du dispositif 3, dite d'initialisation ("forming" en anglais) lors de laquelle une tension est appliquée au dispositif 3. Dès lors que cette tension atteint une tension de rupture, le filament est créé dans la couche 27. Lors de l'initialisation, le courant est inférieur à une valeur limite pour laquelle les matériaux des couches 25 et 27 se liquéfient et fusionnent.

Le pourcentage en azote dans la couche 27 est choisi en fonction de la tension de rupture souhaitée pour le matériau de la couche 27 et de la résistance électrique souhaitée pour ce même matériau. Selon un mode de réalisation, le pourcentage en azote est compris entre 25 % et 35 %. La couche 27 a une épaisseur e3 choisie, par exemple, de sorte que la tension de rupture soit suffisamment faible sans que celle-ci ait une variabilité importante. L'épaisseur e3 de la couche 27 est alors, par exemple, comprise entre 2 nm et 30 nm, et dans certains exemples, comprise entre 3 nm et 25 nm.

Lors de l'étape d'initialisation, et à la suite de la création du filament, une partie du matériau à changement de phase de la couche 25 est liquéfiée et remplit l'intérieur du filament pour former un volume 29 dit "zone confinée" ou canal.

Selon un autre mode de réalisation, la couche 27 est une couche en un diélectrique qui comprend une zone confinée 29 formée, par exemple, par gravure suivie d'un remplissage d'un matériau à changement de phase, par exemple, le même matériau que la couche 25.

La couche PCM 25 a, par exemple, une épaisseur e1 comprise entre 10 nm et 200 nm et égale, par exemple, à environ 50 nm. Selon le mode de réalisation illustré en figure 3, la couche 25 et la couche 27 ont, par exemple, une largeur sensiblement égale à la largeur de l'électrode 23, de l'électrode 21 et, éventuellement, de l'élément chauffant 24. Les couches PCM 25 et GeN 27 ont, par exemple, une largeur comprise entre 3 nm et 500 nm et égale, par exemple, à environ 50 nm.

Selon le mode de réalisation illustré en figure 3, le volume 31 est situé en vis-à-vis du volume 29. La surface de la base du dôme 31 est légèrement supérieure à la surface de la face supérieure du volume 29.

Un avantage qui apparaît de la présence d'une couche de nitrure de germanium entre la couche du matériau à mémoire de phase et l'électrode basse est que le nitrure de germanium a une grande compatibilité physico-chimique.

La figure 4 est une vue en coupe, partielle et schématique, d'une variante de réalisation du dispositif 3 illustré en figure 3.

Plus particulièrement, la figure 4 illustre un dispositif 4 similaire au dispositif 3 illustré en figure 3 à la différence près qu'il comprend une couche 35 entre la couche 27 et l'élément chauffant 24.

Selon le mode de réalisation illustré en figure 4, la couche 35 est composée d'un matériau à changement de phase, par exemple, de même nature que la couche 25.

Selon le mode de réalisation illustré en figure 4, un volume 37 de la couche 35 est également impliqué dans le basculement entre les phases résistive et faiblement résistive. Le volume 37 a la forme d'un dôme renversé c'est-à-dire que sa base est à l'interface entre la couche 27 et la couche 35.

Le dispositif 4 comprend, ainsi, lors de l'augmentation de la température, deux dômes en tête-bêche, c'est-à-dire que leurs faces planes, ou bases, se font face.

Pour effectuer l'opération de RESET, le dôme ou volume 31 illustré en figures 2 à 4 est basculé dans un état résistif et pour effectuer l'opération de SET, le dôme ou volume 31 est basculé dans un état faiblement résistif.

Chacune des opérations de SET et de RESET, si elle fait suite à une précédente opération de RESET, comprend par exemple une première transition dite électronique lors de laquelle une impulsion électrique relativement longue (quelques nanosecondes) et de faible intensité (mais de tension supérieure à la tension de seuil) est appliquée à travers les électrodes 21 et 23. Cette première transition a pour but de basculer le volume 31 d'un état résistif à un état conducteur, dite également transition "threshold", l'état conducteur permettant le passage du courant puis l'entrainement de l'échauffement.

Par la suite, une deuxième transition dite "de phase" est mise en oeuvre soit dans le cadre d'une opération de SET lors de laquelle le matériau à changement de phase bascule d'un état résistif à un état moins résistif, soit dans le cadre d'une opération de RESET, où le matériau à changement de phase bascule d'un état moins résistif à un état résistif

Selon un mode de réalisation, l'évolution de la densité de courant $J_0(t)$ propagée dans les dispositifs 2, 3 et 4 en fonction du temps afin de basculer le volume 31 dans un état moins résistif (opération SET) comprend :

  une étape d'augmentation de la densité de courant en fonction du temps afin de rendre le matériau du volume 31 conducteur ; et

  une étape de diminution monotone de la densité de courant en fonction du temps afin de basculer le matériau du volume 31 dans un état moins résistif.

Si, pendant le deuxième temps, la vitesse n'est pas suffisamment lente, le volume 31 repasse dans un état résistif.

Le courant appliqué entre les deux électrodes 21 et 23 et la densité surfacique de courant sont reliés par la formule :

[Math 1]

$$I_{prog} = A.J_{prog}$$

dans laquelle $I_{prog}$ est le courant de programmation 27 appliqué entre les électrodes 21 et 23, $I_{prog}$ est la densité de courant de programmation, et A est la surface mentionnée ci-dessus et A est une surface définie comme étant :

  l'aire de la zone de contact entre le volume 31 et l'élément chauffant 24 ou l'électrode 21 dans le cas du dispositif 2 ; ou l'aire de la plus petite section du canal 29 de la couche 27 dans le cas des dispositifs 3 et 4.

Un avantage qui apparaît de la présence d'une couche comprenant un filament entre la couche du matériau à mémoire de forme phase et l'électrode basse est que la surface A est réduite. Une même densité de courant peut, ainsi, être obtenue avec un courant de programmation plus faible.

Un avantage qui apparaît avec la présence de la couche 35 entre la couche 27 et l'élément chauffant 24 est que les pertes thermiques issues de l'interface entre la couche 27 et l'élément 24 sont diminuées grâce à la relativement faible conductivité thermique du matériau de la couche 35, l'isolation thermique est ainsi augmentée.

La figure 5 est un schéma bloc illustrant un circuit 5 de mémoire à changement de phase comprenant une partie dédiée aux mémoires à changement de phase et une partie dédiée à la programmation de ces dernières.

Plus particulièrement, le système 5 comprend une unité de programmation (PROGRAMMING UNIT) 45 et une matrice 46 d'une ou plusieurs cellules (CELL(S)) de mémoire à changement de phase. Chaque cellule de la matrice 46 comprend un dispositif tel qu'illustré en figures 1 à 4. Les dispositifs sont, par exemple, montés électriquement en dérivation les uns par rapport aux autres.

Selon le mode de réalisation illustré en figure 5, l'unité de programmation 45 génère un courant **I$_{prog}$** qui passe dans chaque cellule de la matrice 46. Au sein de chaque cellule, le dispositif est traversé par une densité surfacique de courant **J$_{prog}$**, correspondant au courant **I$_{prog}$** divisé par la surface **A.**

Selon un mode de réalisation, l'évolution de la densité de courant propagé dans le dispositif en fonction du temps afin de basculer totalement ou partiellement le volume 31 d'un état résistif à un état moins résistif (opération SET) comprend :

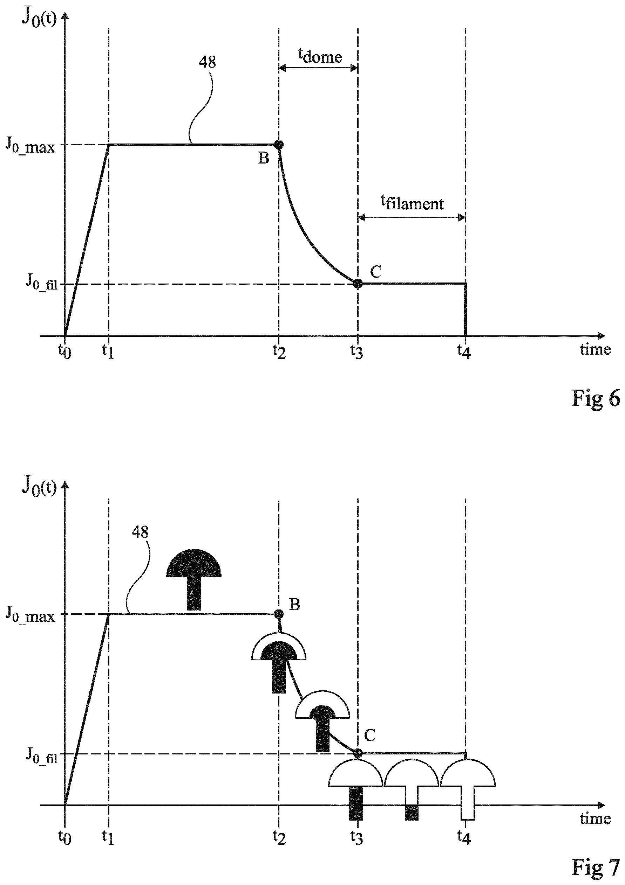

une étape d'augmentation de la densité de courant en fonction du temps afin de rendre le matériau du volume 31 conducteur ; et

une étape de diminution non linéaire de la densité de courant en fonction du temps afin de rendre le matériau du volume 31 moins résistif, cette étape étant décrite plus en détails, ci-après, en relation avec les figures 6 à 12.

A titre d'exemple, la diminution non linéaire de la densité de courant en fonction du temps est commandée par un convertisseur numérique analogique faisant partie de l'unité de programmation 45. En particulier, la forme de la décroissance est, par exemple, définie par une séquence de valeurs numériques, qui sont, par la suite, converties en signal de commande analogique par ce convertisseur.

La figure 6 représente un mode de réalisation de l'évolution de la densité de courant propagé dans le dispositif 3 illustré en figure 3 en fonction du temps afin de basculer une partie des matériaux à changement de phase de ce dispositif d'un état résistif à un état moins résistif. Ce mode de réalisation s'applique aux dispositifs similaires au dispositif 3 de la figure 3 comprenant une zone confinée, c'est-à-dire un canal d'une largeur très inférieure à la largeur de la couche 25.

Plus particulièrement, la figure 6 représente une courbe 48 illustrant l'évolution de la densité surfacique de courant $J_0(t)$ dans le canal 29, imposée par un courant I(t) passant par les électrodes en fonction du temps (time).

Selon le mode de réalisation illustré en figure 6, la courbe 48 comprend :

une première portion de croissance linéaire de la densité de courant (deuxième évolution) entre un instant $t_0$ et un instant $t_1$ ;

une deuxième portion de densité de courant sensiblement constante (troisième évolution), au niveau $J_{0\_max}$ entre l'instant $t_1$ et un instant $t_2$ ;

une troisième portion de décroissance non linéaire de la densité de courant (première évolution) entre l'instant $t_2$ et un instant $t_3$, la durée entre les instants $t_2$ et $t_3$ étant nommée $t_{dome}$ ; et

une quatrième portion de densité de courant sensiblement constante (quatrième évolution), au niveau $J_{0\_fil}$, entre l'instant $t_3$ et un instant $t_4$, la durée entre les instants $t_3$ et $t_4$ étant nommée $t_{filament}$.

La figure 7 représente la même courbe 48 que la figure 6 et montre en outre l'évolution structurelle du changement d'état des volumes 31 et 29 du matériau à changement de phase.

A l'instant $t_0$, le matériau à changement de phase du volume 31 est résistif et la densité de courant est, par exemple à un niveau 0. Entre les instants $t_0$ et $t_1$, la densité de courant augmente de façon à atteindre, à l'instant $t_1$, une valeur en densité de courant $J_{0\_max}$ qui restera sensiblement constante jusqu'à l'instant $t_2$ (point B). Entre les instants $t_0$ et $t_2$, le matériau à changement de phase du volume 31 devient conducteur.

Entre l'instant $t_2$ et l'instant $t_3$, pendant la durée $t_{dome}$, le matériau à changement de phase du volume 31, en particulier le dôme correspondant au volume 31, bascule vers un état moins résistif. Le changement d'état du volume 31 s'effectue à partir de l'extérieur du volume 31 vers l'intérieur du volume 31, c'est-à-dire à partir de la face bombée du dôme vers la face plane de celui-ci.

Lors de la durée $t_{dome}$, la courbe 48 décroit, c'est-à-dire que la densité de courant diminue en fonction du temps. Pour satisfaire à un changement d'état total du volume 31, la vitesse de croissance de la cristallisation, pour un volume ayant la forme d'un dôme, respecte la formule suivante :

[Math 2]

$$\frac{\partial J_0(t)}{\partial t} < \frac{v_g}{2h.\,(T_{melt} - T_h)} \frac{[\delta(J_0(t))^2 - T_h]^2}{\delta J_0(t)}$$

dans laquelle : $v_g$ est la vitesse de cristallisation du matériau à changement de phase, $h$ est la hauteur de la couche du matériau à changement de phase, $T_{melt}$ est la température de fusion du matériau à changement de phase et $T_h$ est la température à l'interface entre la deuxième électrode et la couche du matériau à changement de phase et $\delta$ suit la formule :

[Math 3]

$$\delta = R_{th}.A^2.R_h$$

dans laquelle $R_{th}$ est la résistance thermique du dispositif et $R_h$ est la résistance électrique du matériau du dôme 29.

Ainsi, si $\delta(J_0(t))^2 \gg T_h$, la formule [Math 2] peut être simplifiée pour donner :

[Math 4]

$$\frac{\partial J_0(t)}{\partial t} < \frac{v_g \delta(J_0(t))^3}{2h.(T_{melt} - T_h)}$$

ou encore

[Math 5]

$$-\frac{H}{2}(J_0(t))^3 < \frac{\partial J_0(t)}{\partial t} < 0$$

dans laquelle :

[Math 6]

$$H = \frac{v_g.R_{th}.A^2.R_h}{h.(T_{melt} - T_h)}.$$

A titre d'exemple, la solution à la formule [Math 5] correspond à :

[Math 7]

$$J_0(t) = K\frac{1}{\sqrt{t}}$$

pour laquelle K est un constante et est le coefficient directeur de la courbe. Dans certains modes de réalisation, la constante K est égale à :

[Math 8]

$$K = \frac{1}{\sqrt{H}}$$

d'où

[Math 9]

$$J_0(t) = \frac{1}{\sqrt{Ht}}.$$

Le basculement dans un état moins résistif est terminé, par exemple, lorsque, est vérifiée, la formule :

[Math 10]

$$J_0(t) = \sqrt{\frac{T_{melt}}{R_{th}.A^2.R_h}}.$$

Ainsi, $t_{dome}$ vérifie l'équation :

[Math 11]

$$t_{dome} = \frac{h.(T_{melt}-T_h)}{v_g.T_{melt}}.$$

Ainsi $t_{dome}$ est optimisé pour chaque matériau à changement de phase. A titre d'exemple, la durée $t_{dome}$ est comprise entre 1 ns et 1 ps.

Entre les instants $t_3$ et $t_4$, pendant la durée $t_{filament}$, le matériau à changement de phase du dôme 29, c'est-à-dire le matériau présent à l'intérieur du filament, bascule dans un état moins résistif. Le changement d'état du dôme 29 s'effectue, par exemple, à partir de la face supérieure de la couche 27, c'est à dire à partir de l'interface entre la couche 27 et la couche 25 vers la face inférieure de la couche 27, c'est-à-dire vers l'interface entre la couche 27 et l'élément 24.

Lors de la durée $t_{filament}$, selon le mode de réalisation illustré en figures 6 et 7, la courbe 48 est constante, et par exemple au niveau $J_{0\_fil}$. La durée $t_{filament}$ dépend de la hauteur $h_{filament}$ de la couche 27 et donc du filament et correspond à :

[Math 12]

$$t_{filament} = \frac{h_{filament}}{v_g}.$$

A l'instant $t_4$, le basculement du matériau à changement de phase des volumes 29 et 31 dans un état faiblement résistif est par exemple fini et la densité de courant diminue. Le dispositif est ainsi prêt pour un nouveau cycle d'écriture.

A titre d'exemple, la durée $t_{filament}$ est comprise entre 1 ns et 10 ps pour un filament ayant une hauteur compris entre 5 nm et 30 nm.

Dans le cadre d'un dispositif comprenant une couche 35 et un double dôme tel qu'illustré dans le dispositif 4 représenté en figure 4, le volume 37 bascule dans un état moins résistif entre les instants $t_2$ et $t_3$.

Un avantage de suivre l'évolution de la densité de courant en fonction du temps décrite ci-avant est qu'elle permet d'optimiser la cristallisation de la zone active du dispositif c'est-à-dire qu'elle permet de cristalliser totalement les zones actives en un temps réduit et en utilisant un courant réduit en comparaison aux techniques existantes. Un avantage de suivre l'évolution de la densité de courant en fonction du temps décrite ci-avant est qu'elle permet de maîtriser la cristallisation des volumes du matériau à changement de phase afin qu'elle soit totale dans les volumes considérés.

Le graphique illustré en figures 6 et 7 à été décrit et expliqué en considérant une couche 27 en nitrure de germanium dans lequel un filament a été formé, toutefois cette évolution s'adapte également à un dispositif comprenant une couche 27 en un diélectrique dans lequel un canal de PCM a été formé par gravure.

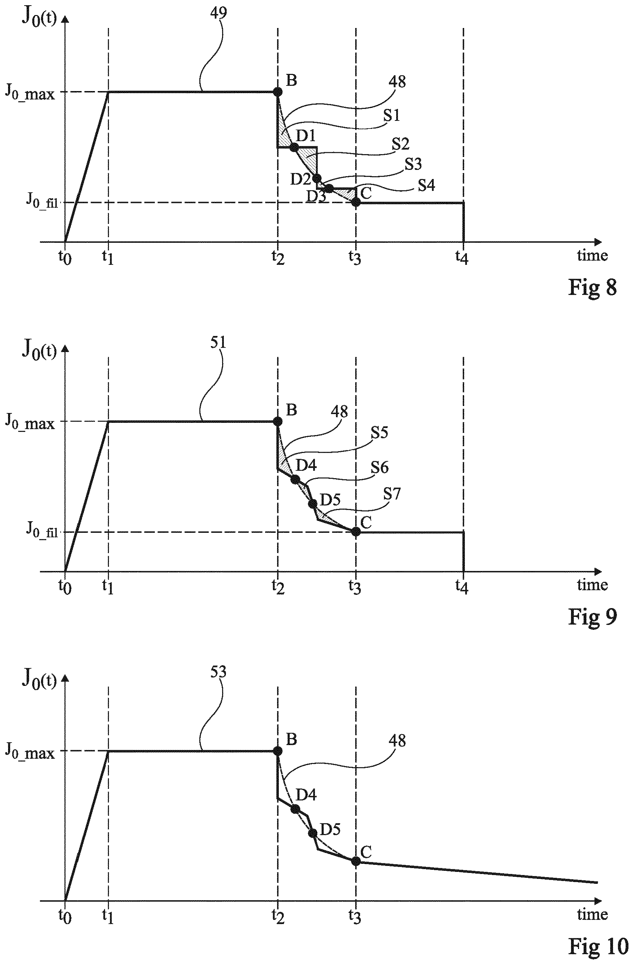

Les figures 8 à 10 représentent d'autres modes de réalisation de l'évolution de la densité de courant propagé dans les dispositifs 3 et 4 illustrés en figures 3 et 4 en fonction du temps afin de basculer une partie des matériaux à changement de phase de ces dispositifs d'un état résistif à un état faiblement résistif.

Plus particulièrement, la figure 8 représente une courbe 49 illustrant un mode de réalisation de l'évolution de la densité de courant en fonction du temps similaire à celle illustrée en figures 6 et 7 à la différence près que la courbe 49 représentée en figure 10 est différente, mais proche, de la courbe 48 entre les instants $t_2$ et $t_3$.

L'exemple de la figure 8 est basé sur une décroissance en forme d'escaliers. Une telle forme est, par exemple, simple à réaliser par un convertisseur numérique analogique tel que décrit en relation avec la figure 5.

Selon le mode de réalisation illustré en figure 8, la courbe 49 passe par les points B et C respectivement aux instants $t_2$ et $t_3$. En figure 8, entre les instants $t_2$ et $t_3$, la courbe 49 est segmentée en créneaux décroissants. En d'autres termes, entre les instants $t_2$ et $t_3$, la courbe 49 correspond par exemple à une succession de portions constantes et de portions de niveaux de densités de courant de plus en plus faibles. En figure 8, la courbe 49 coupe la courbe 48, entre les points B et C, trois fois aux points D1, D2 et D3. Selon le mode de réalisation, la courbe 49 coupe, entre les instants $t_2$ et $t_3$, la courbe 48 en formant des surfaces entre ces deux courbes. En figure 8, entre les courbes 48 et 49, il y a une surface S1 entre les points B et D1, une surface S2 entre les points D1 et D2, une surface S3 entre les points D2 et D3 et une surface S4 entre les points D3 et C.

Par exemple, chacune des surfaces S1, S2, S3 et S4 a une aire inférieure à 20 % de l'intégrale de la courbe 48 entre les instants $t_2$ et $t_3$. Dans certains cas, chacune des surfaces S1, S2, S3 et S4 a une aire inférieure à 10 % de l'intégrale de la courbe 48 entre les instants $t_2$ et $t_3$.

En figure 8, la courbe 49 coupe la courbe 48 trois fois entre les instants $t_2$ et $t_3$ pour former quatre surfaces toutefois en pratique, la courbe 49 peut couper une fois, deux fois ou plus de deux fois la courbe 48 de façon à former deux surfaces, trois surfaces ou plus de trois surfaces entre les courbes 48 et 49.

De même, la figure 9 représente une courbe 51 illustrant un mode de réalisation de l'évolution de la densité de courant en fonction du temps similaire à celle illustrée en figures 6 et 7 à la différence près que la courbe 51 représentée en figure 9 est différente de la courbe 48 entre les instants $t_2$ et $t_3$.

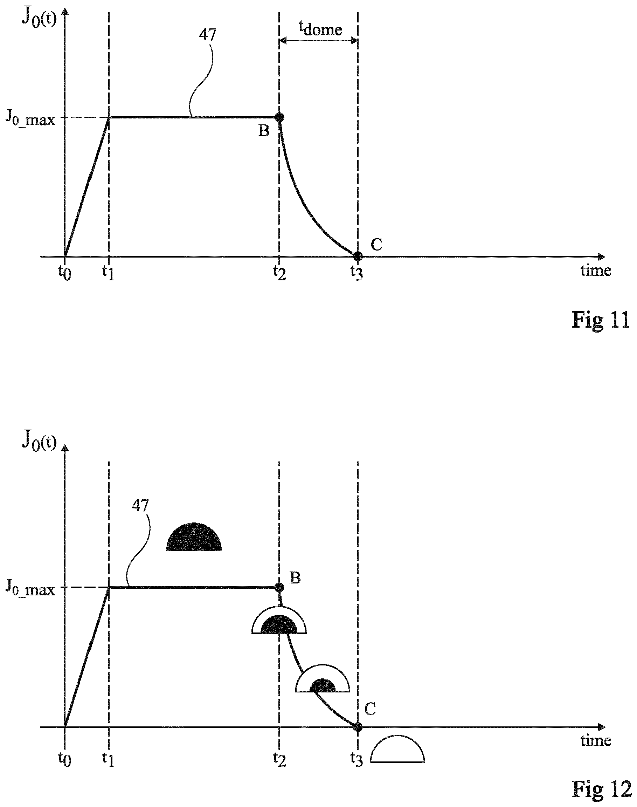

Selon le mode de réalisation illustré en figure 9, la courbe 51 passe par les points B et C respectivement aux instants $t_2$ et $t_3$. En figure 11, entre les instants $t_2$ et $t_3$, la courbe 51 est segmentée en portions strictement décroissantes et coupe la courbe 48, entre les points B et C, deux fois aux points D4 et D5. Selon le mode de réalisation, la courbe 51 coupe, entre les instants $t_2$ et $t_3$, la courbe 48 en formant des surfaces entre ces deux courbes. En figure 9, entre les courbes 48 et 51, il y a une surface S5 entre les points B et D4, une surface S6 entre les points D4 et D5 et une surface S7 entre les points D5 et C.

Chacune des surfaces S5, S6 et S7 a une aire inférieure à 10 % de l'intégrale de la courbe 48 entre les instants $t_2$ et $t_3$. Par exemple, chacune des surfaces S5, S6 et S7 a une aire inférieure à 5 % de l'intégrale de la courbe 48 entre les instants $t_2$ et $t_3$.

En figure 9, la courbe 51 coupe la courbe 48 deux fois entre les instants $t_2$ et $t_3$ pour former trois surfaces toutefois en pratique, la courbe 51 peut couper une fois, deux fois ou plus de deux fois la courbe 48 de façon à former deux surfaces, trois surfaces ou plus de trois surfaces entre les courbes 48 et 51.

A titre d'exemple, la pente moyenne de la première évolution entre B et C est proche d'une pente qui respecte la relation $$J_0(t) = K\frac{1}{\sqrt{t}}$$ .

De même, la figure 10 représente une courbe 53 illustrant un mode de réalisation de l'évolution de la densité de courant en fonction du temps similaire à celle illustrée en figure 9 à la différence près que la courbe 53 représentée en figure 10 est différente de la courbe 51 après l'instant $t_3$.

Selon le mode de réalisation illustré en figure 10, la courbe 53 est décroissante après l'instant $t_4$.

La figure 11 représente un mode de réalisation de l'évolution de la densité de courant $J_0(t)$ propagé dans le dispositif 2 illustré en figure 2 en fonction du temps et plus particulièrement, dans le volume 31, afin de basculer une partie des matériaux de ces dispositifs d'un état résistif à un état faiblement résistif.

Plus particulièrement, la figure 11 représente une courbe 47 illustrant l'évolution de la densité de courant $J_0(t)$, imposée par un courant $I(t)$ passant par les électrodes en fonction du temps (time).

Selon le mode de réalisation illustré en figure 11, la courbe 47 comprend, similairement à la courbe 48 illustrée en figures 6 et 7 :

une première portion de croissance linéaire de la densité de courant entre l'instant $t_0$ et l'instant $t_1$ ;

une deuxième portion de densité de courant sensiblement constante entre l'instant $t_1$ et l'instant $t_2$ ; et

une troisième portion de décroissance non linéaire de la densité de courant entre l'instant $t_2$ et l'instant $t_3$.

La figure 12 représente la même courbe 47 que la figure 11 et montre en outre l'évolution structurelle du changement d'état dans le volume 31 de matériau à changement de phase.

Similairement à la courbe 48, lors de la durée $t_{dome}$, la courbe 47 décroit, c'est-à-dire que la densité de courant diminue en fonction du temps. Pour satisfaire à une bonne cristallisation du volume 31, la densité de courant vérifie par exemple la formule :

[Math 7]

$$J_0(t) = K\frac{1}{\sqrt{t}}$$

dans laquelle :

[Math 13]

$$K = \frac{1}{\sqrt{H'}} \text{ avec :}$$

$$H = \frac{v_g.R_{th}.A^2.R_h{}'}{h.(T_{melt} - T_h)}$$

avec $R_h$' est la résistance de l'élément chauffant 24.

Ainsi, $t_{dome}$ vérifie l'équation :

[Math 14]

$$t_{dome} = \frac{h.(T_{melt} - T_h)}{v_g.T_{melt}}.$$

A titre d'exemple, la durée $t_{dome}$ est comprise entre 1 ns et 1 μs.

A l'instant $t_3$, l'ensemble du matériau à changement de phase présent dans le volume 31 bascule dans un état faiblement résistif. Le dispositif est ainsi prêt pour un nouveau cycle d'écriture.

Un avantage des modes de réalisation et des modes de mise en oeuvre décrits est qu'ils sont compatibles avec les lignes de production usuelles des composants en microélectronique.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les variantes de la courbe 48 illustrées en figures 8 à 10 peuvent s'appliquer à l'évolution de la courbe 47 représentée en figures 11 et 12.

Enfin, la mise en oeuvre pratique des modes de réalisation et variantes décrits est à la portée de la personne du métier à partir des indications fonctionnelles données ci-dessus.

**Revendications**

1. Procédé de programmation d'une mémoire à changement de phase comprenant une première couche (25) d'un matériau à changement de phase capable de passer entre un état cristallin et un état amorphe et inversement, le procédé comprenant l'application d'un courant de programmation à travers la première couche de sorte qu'une évolution de la densité surfacique de ce courant ($J_0$) en fonction du temps t décroisse à partir d'un premier niveau ($J_{0\_max}$), entre un premier instant ($t_2$) et un deuxième instant ($t_3$), en suivant une première évolution dans le temps respectant, ou étant proche de $J_0(t) = \dfrac{K}{\sqrt{t}}$ où K est une constante, **caractérisé en ce que** la première évolution est proche de $J_0(t) = \dfrac{K}{\sqrt{t}}$ si elle crée, lorsqu'elle est superposée à celle-ci, une ou plusieurs surfaces entre la première évolution et $J_0(t) = \dfrac{K}{\sqrt{t}}$, et le rapport de l'aire de chaque surface avec l'intégrale de $J_0(t) = \dfrac{K}{\sqrt{t}}$ entre les premier et deuxième instants ($t_2$, $t_3$) est inférieur à 0,2.

2. Procédé selon la revendication 1, dans lequel la première évolution coupe $J_0(t) = \dfrac{K}{\sqrt{t}}$ au moins en deux points entre les premier et deuxième instants ($t_2$, $t_3$).

3. Procédé selon la revendication 1 ou 2, dans lequel, avant le premier instant ($t_2$) l'évolution de la densité surfacique du courant ($J_0$) en fonction du temps t, suit une deuxième évolution croissante linéaire entre un troisième instant ($t_0$) et un quatrième instant ($t_1$) puis une troisième évolution constante égale au premier niveau entre le quatrième instant ($t_1$) et le premier instant ($t_2$).

4. Procédé selon l'une quelconque des revendications 1 à 3, dans lequel la première évolution comprend plusieurs portions linéaires strictement décroissantes et/ou des proportions constantes, entre le premier instant ($t_2$) et le deuxième instant ($t_3$).

5. Procédé selon l'une quelconque des revendications 1 à 4, dans lequel la première couche (25) repose sur un élément chauffant (24) ou une électrode (21).

6. Procédé selon l'une quelconque des revendications 1 à 4, dans lequel la première couche (25) repose sur une deuxième couche (27) à base de nitrure de germanium.

7. Procédé selon la revendication 6, dans lequel le courant de programmation est appliqué à travers la première couche (25) et un canal dans la deuxième couche (27), une zone de contact (A) entre le canal et la face inférieure de la première couche ayant une superficie inférieure à celle de la face inférieure de la première couche.

8. Procédé selon la revendication 7, dans lequel le canal est une zone confinée d'un matériau à changement de phase et est situé dans un filament de la deuxième couche, le procédé comprenant, après le deuxième instant ($t_3$), une étape de cristallisation de la zone confinée.

9. Procédé selon la revendication 8, dans lequel une cristallisation de la zone confinée (29) est menée par une quatrième évolution linéaire constante de la densité de courant ($J_0$) en fonction du temps (t), sur une première durée (*$t_{filament}$*) et dans lequel la première durée est égale à $t_{filament} = \dfrac{h_{filament}}{v_g}$ avec *$h_{filament}$* la hauteur moyenne de la zone confinée (29) et avec *$v_g$* la vitesse de cristallisation du matériau à changement de phase.

10. Procédé selon l'une quelconque des revendications 8 à 9, dans lequel la cristallisation de la zone confinée (29) est menée par une évolution linéaire strictement décroissante de la densité de courant ($J_0$) en fonction du temps (t).

11. Procédé selon l'une quelconque des revendications 8 à 10, dans lequel $K = \dfrac{1}{\sqrt{H}}$ où $H = \dfrac{v_g.R_{th}.A^2.R_h}{h.(T_{melt}-T_h)}$ avec *$R_{th}$* la résistance thermique de la cellule, *$R_h$* la résistance électrique du matériau à changement de phase dans le filament, **A** la superficie de la zone de contact (A) entre le filament et la face inférieure de la première couche, **h** la hauteur maximale du matériau à changement de phase, *$T_{melt}$* la température de fusion du matériau à changement de phase, et avec *$T_h$* la température de la première couche à sa face supérieure, c'est-à-dire à la face opposée à la face inférieure.

12. Procédé selon la revendication 5, dans lequel $K = \dfrac{1}{\sqrt{H'}}$ où $H' = \dfrac{v_g.R_{th}.A^2.R_{h'}}{h.(T_{melt}-T_h)}$ avec *$R_{th}$* la résistance thermique

de la cellule, $R_h{'}$ la résistance électrique de l'élément chauffant, **A** la superficie de la zone de contact (A) entre l'électrode ou l'élément chauffant et la face inférieure de la première couche, **h** la hauteur maximale du matériau à changement de phase, $T_{melt}$ la température de fusion du matériau à changement de phase, et avec $T_h$ la température de la première couche à sa face supérieure, c'est-à-dire à la face opposée à la face inférieure.

13. Procédé selon la revendication 5 ou 12, dans lequel la durée entre les premier et deuxième instants ($t_2$, $t_3$), est égale à une deuxième durée $$t_{d\hat{o}me} = \frac{h.(T_{melt} - T_h)}{v_g.T_{melt}}$$ .

14. Procédé selon l'une quelconque des revendications 1 à 13, dans lequel la durée ($t_{d\hat{o}me}$) entre les premier et deuxième instants ($t_2$, $t_3$) est compris entre 1 ns et 1 ps.

15. Procédé selon l'une quelconque des revendications 1 à 14, dans lequel le premier niveau est un niveau maximum que la densité de courant atteint par la cellule au cours des cycles de programmation.

16. Procédé selon l'une quelconque des revendications 1 à 15, dans lequel l'application du courant de programmation (I) correspond à une cristallisation (SET) d'une partie de la première couche.

**Patentansprüche**

1. Ein Verfahren zum Programmieren eines Phasenwechsel-Speichers aufweisend eine erste Schicht (25) eines Phasenwechsel-Materials, das in der Lage ist, zwischen einem kristallinen und einem amorphen Zustand und umgekehrt zu wechseln, wobei das Verfahren das Anlegen eines Programmierstroms durch die erste Schicht aufweist, so dass eine Entwicklung der Flächenstromdichte ($J_0$) als eine Funktion der Zeit t abnimmt von einem ersten Niveau ($J_{0\_max}$) zwischen einem ersten Zeitpunkt ($t_2$) und einem zweiten Zeitpunkt ($t_3$), und zwar nach einer ersten Entwicklung in der Zeit entsprechend oder in der Nähe von $J_0(t) = \frac{K}{\sqrt{t}}$ , wobei K eine Konstante ist,

   **dadurch gekennzeichnet, dass** die erste Entwicklung nahe an $J_0(t) = \frac{K}{\sqrt{t}}$ ist, wenn sie, wenn sie überlagert wird, eine oder mehrere Oberflächen zwischen der ersten Entwicklung und $J_0(t) = \frac{K}{\sqrt{t}}$ erzeugt, und das Verhältnis der Fläche jeder Oberfläche zu dem Integral von $J_0(t) = \frac{K}{\sqrt{t}}$ zwischen dem ersten und dem zweiten Zeitpunkt ($t_2$, $t_3$) kleiner als 0,2 ist.

2. Das Verfahren nach Anspruch 1, wobei die erste Entwicklung $J_0(t) = \frac{K}{\sqrt{t}}$ an wenigstens zwei Punkten zwischen den ersten und zweiten Zeitpunkten ($t_2$, $t_3$) schneidet.

3. Das Verfahren nach Anspruch 1 oder 2, wobei vor dem ersten Zeitpunkt ($t_2$) die Entwicklung der Flächenstromdichte ($J_0$) als Funktion der Zeit t einer zweiten linear ansteigenden Entwicklung folgt zwischen einem dritten Zeitpunkt ($t_0$) und einem vierten Zeitpunkt ($t_1$) und dann eine dritte konstante Entwicklung gleich dem ersten Niveau zwischen dem vierten Zeitpunkt ($t_1$) und dem ersten Zeitpunkt ($t_2$).

4. Das Verfahren nach einem der Ansprüche 1 bis 3, wobei die erste Entwicklung mehrere streng abnehmende lineare Abschnitte und/oder konstante Anteile aufweist, zwischen dem ersten Zeitpunkt ($t_2$) und dem zweiten Zeitpunkt (t3).

5. Das Verfahren nach einem der Ansprüche 1 bis 4, wobei die erste Schicht (25) auf einem Heizelement (24) oder auf einer Elektrode (21) aufliegt.

6. Das Verfahren nach einem der Ansprüche 1 bis 4, wobei die erste Schicht (25) auf einer zweiten Germaniumnitrid-basierten Schicht (27) aufliegt.

7. Das Verfahren nach Anspruch 6, wobei der Programmierstrom angelegt wird durch die erste Schicht (25) und einen Kanal in der zweiten Schicht (27), wobei eine Kontaktzone (A) zwischen dem Kanal und der unteren Seite der ersten Schicht eine kleinere Fläche hat als die untere Seite der ersten Schicht.

8. Das Verfahren nach Anspruch 7, wobei der Kanal eine eingeschlossene Zone eines Phasenwechselmaterials ist und sich in einem Filament der zweiten Schicht befindet, wobei das Verfahren nach dem zweiten Zeitpunkt ($t_3$) einen Schritt des Kristallisierens der eingeschlossenen Zone aufweist.

9. Das Verfahren nach Anspruch 8, wobei eine Kristallisierung der eingeschlossenen Zone (29) herbeigeführt wird durch eine vierte konstante lineare Entwicklung der Stromdichte ($J_0$) als Funktion der Zeit (t) über eine erste Dauer

($t_{filament}$) und wobei die erste Dauer gleich $t_{filament} = \dfrac{h_{filament}}{v_g}$ ist, wobei $h_{filament}$ die durchschnittliche Höhe der eingeschlossenen Zone (29) und $v_g$ die Kristallisationsgeschwindigkeit des Phasenänderungsmaterials ist.

10. Das Verfahren nach einem der Ansprüche 8 bis 9, wobei die Kristallisierung der eingeschlossenen Zone (29) durch eine streng abnehmende lineare Entwicklung der Stromdichte ($J_0$) mit der Zeit (t) herbeigeführt wird.

11. Verfahren nach einem der Ansprüche 8 bis 10, wobei $K = \dfrac{1}{\sqrt{H}}$ mit $H = \dfrac{v_g \cdot R_{th} \cdot A^2 \cdot R_h}{h \cdot (T_{melt} - T_h)}$ ist, wobei $R_{th}$ der thermische Widerstand der Zelle, $R_h$ der elektrische Widerstand des Phasenwechselmaterials im Filament, A die Fläche der Kontaktzone (A) zwischen dem Filament und der Unterseite der ersten Schicht, $h$ die maximale Höhe des Phasenwechselmaterials, $T_{melt}$ die Schmelztemperatur des Phasenwechselmaterials und $T_h$ die Temperatur der ersten Schicht an ihrer Oberseite, d. h., an der der Unterseite gegenüberliegenden Seite ist.

12. Das Verfahren nach Anspruch 5, wobei $K = \dfrac{1}{\sqrt{H'}}$ ist, wo $H' = \dfrac{v_g \cdot R_{th} \cdot A^2 \cdot R_h{}'}{h \cdot (T_{melt} - T_h)}$, mit $R_{th}$ dem thermischen Widerstand der Zelle, $R_h{}'$ dem elektrischen Widerstand des Heizelements, **A** der Fläche der Kontaktzone (A) zwischen der Elektrode oder dem Heizelement und der Unterseite der ersten Schicht, h der maximalen Höhe des Phasenwechselmaterials, $T_{melt}$ der Schmelztemperatur des Phasenwechselmaterials und mit $T_h$ der Temperatur der ersten Schicht an ihrer Oberseite, d. h., an der der Unterseite gegenüberliegenden Seite.

13. Das Verfahren nach Anspruch 5 oder 12, wobei die Dauer zwischen dem ersten und dem zweiten Zeitpunkt ($t_2$, $t_3$) gleich einer zweiten Dauer $t_{\hat{d}ome} = \dfrac{h \cdot (T_{melt} - T_h)}{v_g \cdot T_{melt}}$ ist.

14. Das Verfahren nach einem der Ansprüche 1 bis 13, wobei die Dauer ($t_{\hat{d}ome}$) zwischen dem ersten und zweiten Zeitpunkt ($t_2$, $t_3$) zwischen 1 ns und 1 μs liegt.

15. Das Verfahren nach einem der Ansprüche 1 bis 14, wobei der erste Wert ein maximaler Stromdichtewert ist, den die Zelle während der Programmierzyklen erreicht.

16. Das Verfahren nach einem der Ansprüche 1 bis 15, wobei das Anlegen des Programmierstroms (I) einer Kristallisierung (SET) eines Teils der ersten Schicht entspricht.

**Claims**

1. A method of programming a phase change memory comprising a first layer (25) of a phase change material capable of switching between a crystalline and an amorphous state and vice versa, the method comprising the application of a programming current through the first layer such that an evolution of the areal current density ($J_0$) as a function of time t decreases from a first level ($J_{0\_max}$), between a first time instant ($t_2$) and a second time instant ($t_3$), following a first evolution in time respecting, or being close to, $J_0(t) = \dfrac{K}{\sqrt{t}}$ where K is a constant,

**characterized in that**, the first evolution is close to $J_0(t) = \frac{K}{\sqrt{t}}$ if it creates, when superimposed thereon, one or more surfaces between the first evolution and $J_0(t) = \frac{K}{\sqrt{t}}$, and the ratio of the area of each surface to the integral of $J_0(t) = \frac{K}{\sqrt{t}}$ between the first and the second time instants ($t_2$ , $t_3$) is less than 0.2.

2. The method according to claim 1, wherein the first evolution intersects $J_0(t) = \frac{K}{\sqrt{t}}$ at least at two points between the first and second time instants ($t_2$, $t_3$).

3. The method according to claim 1 or 2, wherein, prior to the first time instant ($t_2$) the evolution of the areal current density ($J_0$) as a function of time t, follows a second linear increasing evolution between a third time instant ($t_0$) and a fourth time instant ($t_1$) then a third constant evolution equal to the first level between the fourth time instant ($t_1$) and the first time instant ($t_2$).

4. The method according to any one of claims 1 to 3, wherein the first evolution comprises several strictly decreasing linear portions and/or constant proportions, between the first time instant ($t_2$) and the second time instant ($t_3$).

5. The method according to any one of claims 1 to 4, wherein the first layer (25) rests on a heating element (24) or on an electrode (21).

6. The method according to any one of claims 1 to 4, wherein the first layer (25) rests on a second germanium nitride based layer (27).

7. The method according to claim 6, wherein the programming current is applied through the first layer (25) and a channel in the second layer (27), a contact zone (A) between the channel and the lower face of the first layer having a smaller area than the lower face of the first layer.

8. The method according to claim 7, wherein the channel is a confined zone of a phase change material and is located in a filament of the second layer, the method comprising, after the second time instant ($t_3$), a step of crystallizing the confined zone.

9. The method according to claim 8, wherein a crystallization of the confined zone (29) is brought about by a fourth constant linear evolution of the current density ($J_0$) as a function of time (t), over a first duration ($t_{filament}$) and wherein the first duration is equal to $t_{filament} = \frac{h_{filament}}{v_g}$ with $h_{filament}$ the average height of the confined zone (29) and with $v_g$ the crystallization velocity of the phase change material.

10. The method according to any one of claims 8 to 9, wherein the crystallization of the confined zone (29) is brought about by a strictly decreasing linear evolution of the current density ($J_0$) with time (t) .

11. The method according to any one of claims 8 to 10, wherein $K = \frac{1}{\sqrt{H}}$ where $H = \frac{v_g.R_{th}.A^2.R_h}{h.(T_{melt}-T_h)}$ with $R_{th}$ the thermal resistance of the cell, $R_h$ the electrical resistance of the phase change material in the filament, **A** the area of the contact zone (A) between the filament and the lower face of the first layer, **h** the maximum height of the phase change material, $T_{melt}$ the melting temperature of the phase change material, and with $T_h$ the temperature of the first layer at its upper face, i.e., at the side opposite the lower face.

12. The method of claim 5, wherein $K = \frac{1}{\sqrt{H'}}$ where $H' = \frac{v_g.R_{th}.A^2.R_h'}{h.(T_{melt}-T_h)}$ with $R_{th}$ the thermal resistance of the cell, $R_h'$ the electrical resistance of the heating element, **A** the area of the contact zone (A) between the electrode or heating element and the lower face of the first layer, **h** the maximum height of the phase change material, $T_{melt}$ the melting temperature of the phase change material, and with $T_h$ the temperature of the first layer at its upper face, i.e., at the face opposite the lower face.

**13.** The method according to claim 5 or 12, wherein the duration between the first and second time instants (t2, t3), is equal to a second duration $t_{d\hat{o}me} = \frac{h.(T_{melt} - T_h)}{v_g.T_{melt}}$ .

**14.** The method according to any one of claims 1 to 13, wherein the duration ($t_{d\hat{o}me}$) between the first and second time instants (t2, t3) is between 1 ns and 1 $\mu$s.

**15.** The method according to any one of claims 1 to 14, wherein the first level is a maximum current density level that the cell reaches during the programming cycles.

**16.** The method according to any one of claims 1 to 15, wherein the application of the programming current (I) corresponds to a crystallization (SET) of a portion of the first layer.

23

31

A

25

26

24

21

**Fig 1**

2

23

31

e1

25

24

A

26

21

**Fig 2**

2

3

23
25
31
A

e4

27
e3

29
24
21

**Fig 3**

4

23
25
31

27
A
29

37
35

24
21

**Fig 4**

46

$I_{prog}$

45

5

CELL(S)

PROGRAMMING
UNIT

**Fig 5**

Fig 6

Fig 7

Fig 8

Fig 9

Fig 10

Fig 11

Fig 12

## RÉFÉRENCES CITÉES DANS LA DESCRIPTION

**Documents brevets cités dans la description**

- US 8634235 B2
- US 2010097851 A1